# EUROPÄISCHE PATENTSCHRIFT

(11) **EP 2 304 451 B1**
(45) Veröffentlichungstag und Bekanntmachung des Hinweises auf die Patenterteilung: **19.10.2016**
(21) Anmeldenummer: 09780646.7
(22) Anmeldetag: 15.07.2009
(51) Int. Cl.: H01C 7/02, H01C 7/04, H01C 7/10

(54) **VERFAHREN ZUR ERHÖHUNG DER ESD-PULSSTABILITÄT EINES ELEKTRISCHEN BAUELEMENTS**
METHOD FOR INCREASING THE ESD PULSE STABILITY OF AN ELECTRICAL COMPONENT
PROCÉDÉ PERMETTANT D'AUGMENTER LA STABILITÉ D'IMPULSION ESD D'UN COMPOSANT ÉLECTRIQUE

(30) Priorität: 16.07.2008 DE 102008033392
(43) Veröffentlichungstag der Anmeldung: 06.04.2011
(73) Patentinhaber: Epcos AG, 81669 München (DE)
(72) Erfinder: FEICHTINGER, Thomas, A-8010 Graz (AT); ALBRECHER, Markus, A-8511 St. Stefan (AT); PÜRSTINGER, Thomas, 8452 Großklein (AT); ENGEL, Günter, A-8430 Leibnitz (AT)
(74) Vertreter: Epping - Hermann - Fischer
(86) Internationale Anmeldenummer: PCT/EP2009/059081
(87) Internationale Veröffentlichungsnummer: WO 2010/007102

(56) Entgegenhaltungen:
- US-A- 5 675 260
- US-A1- 2004 239 346
- GAUTHIER R ET AL: "TLP Systems With Combined 50- and 500-<tex>$Omega$</tex>Impedance Probes and Kelvin Probes" IEEE TRANSACTIONS ON ELECTRONICS PACKAGING MANUFACTURING, IEEE, PISCATAWAY, NY, US, Bd. 28, Nr. 3, 1. Juli 2005 (2005-07-01), Seiten 213-223, XP011139008 ISSN: 1521-334X
- JON E BARTH J ET AL: "TLP Calibration, Correlation, Standards, and New Techniques" IEEE TRANSACTIONS ON ELECTRONICS PACKAGING MANUFACTURING, IEEE, PISCATAWAY, NY, US, Bd. 24, Nr. 2, 1. April 2001 (2001-04-01), XP011020062 ISSN: 1521-334X

## Beschreibung

Die Druckschrift US 2004/0239346 A1 betrifft ein Verfahren zum Ermitteln einer Strom-/Spannungskennlinie eines zu testenden Bauteils. Zum Ermitteln des Strom-/Spannungszusammenhangs wird das zu testende Bauteil mit ESD-Pulsen unterschiedlicher Amplitude gestresst, bis das Bauteil zerstört ist.

Die Druckschrift US 5,675,260 betrifft ein Verfahren zur Auswahl eines gegenüber einer elektrostatischen Entladung möglichst robusten Bauteildesigns. Dabei werden Bauteile von unterschiedlicher Struktur mit ESD-Pulsen gestresst, wobei die Amplitude der Pulse verändert wird, bis ein Bauteilversagen auftritt.

Eine zu lösende Aufgabe ist es, ein Verfahren anzugeben, bei dem die ESD-Pulsstabilität eines elektrischen Bauelements erhöht wird.

Diese Aufgabe wird durch ein Verfahren nach Patentanspruch 1 gelöst. Vorteilhafte Ausgestaltungen des Verfahrens sind Gegenstand von Unteransprüchen.

Es wird ein Verfahren zur Erhöhung der ESD- (Electrostatic Discharge) Pulsstabilität eines elektrischen Bauelements angegeben. Ein bereitgestelltes elektrisches Bauelement wird mittels eines Alterungspulses, der durch einen Pulsgenerator erzeugt wird, vorgealtert. Durch den Alterungspuls wird die Degradation einer elektrischen Kennlinie des Bauelements für weitere ESD-Pulse, die während des Betriebs des elektrischen Bauelements auftreten können, verringert.

Während des Betriebs von den elektrischen Bauelementen können transiente Spannungspulse, wie beispielsweise ESD-Pulse, zu einer deutlichen Degradation der Stromspannungskennlinie von elektrischen Bauelementen führen. Durch eine Degradation der Stromspannungskennlinie erreichen die Bauelemente somit nicht mehr die von den Kunden gewünschten Spezifikationen.

Für das elektrische Bauelement werden bevorzugt lineare oder nichtlineare Widerstände verwendet. Gerade bei diesen Bauelementen treten Probleme durch transiente Pulse auf, die zu einer deutlichen Degradation der Stromspannungskennlinie führen können.

Durch den Alterungspuls wird wenigstens eine elektrische Kenngröße des elektrischen Bauelements verändert. Durch den Alterungspuls wird die ESD-Degradation des elektrischen Bauelements verbessert.

Als lineare oder nichtlineare Widerstände werden beispielsweise Varistoren, diskrete und integrierte Widerstände verstanden.

Bei einem Varistor kann sich bei einem ESD-Puls beispielsweise die Varistorspannung ändern. Die Varistorspannung stellt eine typische Kenngröße von Varistoren dar. Eine typische Kenngröße von nichtlinearen Widerständen ist beispielsweise das Verhältnis vom Strom der durch den Widerstand fließt und der Spannung die am Widerstand anliegt.

Integrierte Widerstände können beispielsweise in einem Vielschichtbauelement integriert sein, das mittels LTCC- (Low Temperature Cofired Ceramics = Niedertemperatur-Einbrand-Keramiken) Technologie hergestellt wurde.

Des Weiteren werden unter nichtlinearen Widerständen beispielsweise temperaturabhängige Widerstände wie NTCs oder PTCs verstanden. Bei NTCs oder PTCs kann sich durch einen ESD-Puls beispielsweise die Abhängigkeit des Widerstands von der Temperatur verändern.

Durch den Alterungspuls wird beispielsweise bei einem Varistor die ESD-Degradation der Varistorspannung, die durch beispielsweise einen 15 kV ESD-Puls hervorgerufen wird, von wenigstens 35 % bei einem ungealterten Varistor auf maximal 1 % verringert. Als Varistorspannung wird dabei die Spannung eines Varistors bezeichnet, die an dem Varistor bei einer Stromstärke von 1 mA abfällt.

Bei diskreten Widerständen tritt durch einen ESD-Puls eine Änderung des Widerstands auf, die durch das Beaufschlagen mit einem Alterungspuls vorweggenommen wird.

Bei PTCs oder NTCs wird durch einen ESD-Puls die temperaturabhängige Widerstandskennlinie beeinflusst. Durch die Voralterung mittels eines Alterungspulses wird diese Veränderung vorweggenommen. Somit tritt bei einer Voralterung des elektrischen Bauelements durch das Anlegen eines Alterungspulses im weiteren Betrieb nur noch eine geringfügige Alterung des Bauelements auf.

Der Alterungspuls weist vorzugsweise eine Pulshöhe von etwa 500 V bis 8000 V auf, wobei der Puls eine Länge von ungefähr 10 ns bis 1000 ns aufweist. Der Alterungspuls weist vorzugsweise eine Anstiegszeit von 0,1 ns bis 10 ns auf. Unter der Anstiegszeit ist die Zeit zu verstehen, die der Puls benötigt, um seinen Signalpegel zwischen zwei definierten Zwischenwerten (üblich sind 10 % und 90 %) zu ändern. Die zuvor angegebenen Werte des Alterungspulses sind sehr stark von dem Design und den Materialien, wie beispielsweise den für das Bauelement verwendeten Keramiken, abhängig.

Die Pulsdegradation der Kennlinie des elektrischen Bauelements wird somit über einen Alterungspuls vorgehalten, wobei die Zielspezifikationswerte des elektrischen Bauelements bei einer Designanpassung eingestellt werden. Die Pulsform des Alterungspulses wird vorzugsweise derart ausgewählt, dass das Bauteil über den Energieeintrag des Alterungspulses vorgealtert, jedoch nicht geschädigt wird. Die in der weiteren Verwendung des elektrischen Bauelements hervorgerufene Alterung durch transiente Pulse, wie ESD, wird durch den zuvor eingetragenen Alterungspuls vorweggenommen, wodurch sich die elektrische Spezifikation des Bauteils verbessern.

In einer Ausführungsform wird der Alterungspuls an einem Varistor angewandt.

Durch den Alterungspuls wird die Varistorspannung des Varistors stabilisiert. Bei einem Varistor handelt es sich um einen spannungsabhängigen Widerstand, der oberhalb einer bestimmten Schwellspannung, die typisch für den jeweiligen Varistor ist, abrupt einen kleinen Widerstand aufweist.

Des Weiteren wird ein elektrisches Bauelement angegeben, das nach Anwendung eines wie oben beschriebenen Verfahrens eine maximale ESD-Degradation einer elektrischen Kennlinie von 1 % aufweist. Bei dem elektrischen Bauelement handelt es sich um einen linearen oder nichtlinearen Widerstand. Unter linearen beziehungsweise nichtlinearen Widerständen werden beispielsweise Varistoren, PTC-Elemente, NTC-Elemente beziehungsweise diskrete oder integrierte Widerstände verstanden. Integrierte Widerstände werden beispielsweise in Vielschichtbauelementen integriert, die in LTCC-Technologie hergestellt sind.

Durch ein zuvor beschriebenes Verfahren kann beispielsweise die Klemmspannung eines Varistors um ungefähr 20 % reduziert werden, falls bei einem Varistor eine Voralterung stattgefunden hat.

Unter der Klemmspannung ist der Spannungsabfall des Varistors zu verstehen, den der Varistor bei einem Stromstoß von mehr als 1 A erfährt.

Das oben beschriebene Verfahren und die Gegenstände werden anhand der folgenden Figuren und Ausführungsbeispiele näher erläutert.

Die nachfolgend beschriebenen Zeichnungen sind nicht als maßstabsgetreu aufzufassen. Vielmehr können zur besseren Darstellung einzelne Dimensionen vergrößert, verkleinert oder auch verzerrt dargestellt sein. Elemente, die einander gleichen oder die die gleiche Funktion übernehmen, sind mit den gleichen Bezugszeichen bezeichnet.
Figur 1 zeigt ein schematisches Profil eines Alterungspulses,
Figur 2 zeigt ein Diagramm der Varistorspannung für gealterte und ungealterte Bauteile.

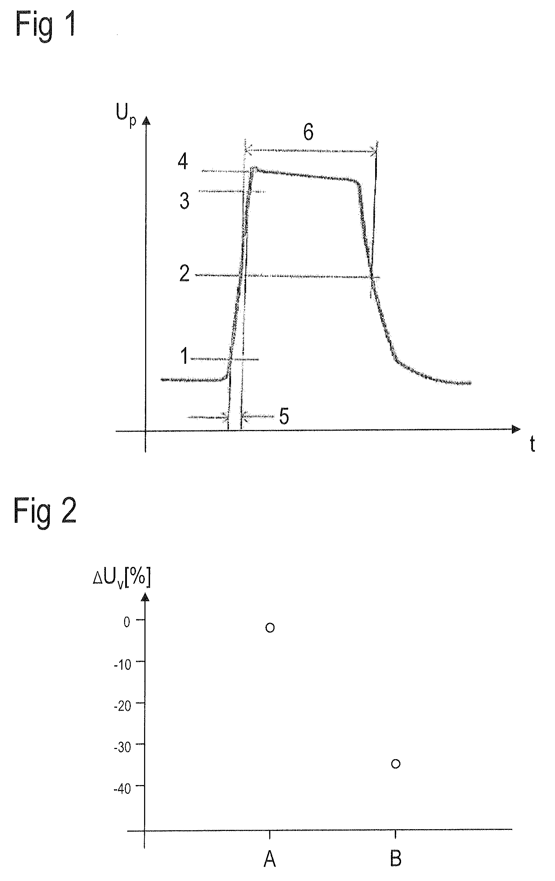

In der Figur 1 ist ein schematisches Profil eines Alterungspulses gezeigt. Auf der x-Achse ist Zeit aufgetragen, auf der y-Achse die Spannung des Alterungspulses Uₚ. Der Alterungspuls weist vorzugsweise eine maximale Pulshöhe 4 von ungefähr 500 V bis 8000 V auf, wobei der Alterungspuls innerhalb einer Zeit 5 von ca. 0,1 ns bis 10 ns von 10% der Pulshöhe 1 auf 90% der Pulshöhe 3 ansteigt. Die Pulslänge 6 beträgt bevorzugt zwischen 10 ns und 1000 ns. Die Pulslänge 6 ist die Breite des Pulses, die der Puls bei 50% der Pulshöhe 2 aufweist.

Der Alterungspuls wird vorzugsweise mittels eines Pulsgenerators erzeugt. Ein elektrisches Bauelement wird mit einem derartigen Alterungspuls vorgepulst. Dadurch wird das elektrische Bauelement durch den Alterungspuls vorgealtert, wobei das Bauelement jedoch nicht geschädigt wird. Die Alterung, die beim nachfolgenden Betrieb des Bauelements auftreten kann, wird durch den Alterungspuls somit nahezu vollständig vorweggenommen.

Die Figur 2 zeigt ein Diagramm, in dem die Änderung der Varistorspannung nach dem Einwirken eines ESD-Pulses auf ein elektrisches Bauelement, in diesem Fall ein Varistor, dargestellt ist. Auf der y-Achse ist die Änderung der Varistorspannung ΔUᵥ in Prozent dargestellt.

Als Varistorspannung wird die Spannung eines Varistors bezeichnet, die der Varistor beim Einbringen eines Stroms von 1mA aufweist.

Auf der x-Achse sind die Bauelemente mit Alterungspuls A und ohne Alterungspuls B aufgetragen. Bei einem Bauelement B, das nicht mit einem Alterungspuls vorgealtert wurde, fällt beispielsweise wie in Figur 2 gezeigt, die Varistorspannung bei einem ESD-Puls von ungefähr 15 kV um wenigstens 35% ab. Wenn das Bauelement A mittels eines Alterungspulses, von beispielsweise 4 kV, vorgealtert wurde, fällt die Varistorspannung dagegen nur um maximal 1% ab.

Obwohl in den Ausführungsbeispielen nur eine beschränkte Anzahl möglicher Weiterbildung der Erfindung beschrieben werden konnte ist die Erfindung nicht auf diese beschränkt. Es ist prinzipiell möglich, dass das Verfahren auch auf andere elektrische Bauelemente angewendet werden kann, die durch transiente Pulse altern.

### Bezugszeichenliste:

- 1: 10% Pulshöhe
- 2: 50% Pulshöhe
- 3: 90% Pulshöhe
- 4: maximale Pulshöhe
- 5: Anstiegszeit
- 6: Pulslänge
- A: Bauelement mit Voralterung
- B: Bauelement ohne Voralterung

## Patentansprüche

1. Verfahren zur Erhöhung der ESD-Pulsstabilität eines elektrischen Bauelements,
- wobei von einem Pulsgenerator ein Puls erzeugt wird und ein bereitgestelltes Bauelement mit dem Puls vorgepulst wird,
**dadurch gekennzeichnet, dass**
- der Puls ein Alterungspuls mit einer Pulsform ist, wobei die Pulsform derart gewählt ist, dass das Bauteil über den Energieeintrag des Alterungspulses vorgealtert und nicht beschädigt wird,
- wodurch die Degradation einer elektrischen Kennlinie des Bauelements durch ESD-Pulse, die während des Betriebs des elektrischen Bauelements auftreten, verringert wird.

2. Verfahren nach Anspruch 1, wobei als elektrisches Bauelement ein linearer oder nichtlinearer Widerstand verwendet wird.

3. Verfahren nach Anspruch 1, wobei wenigstens eine elektrische Kenngröße des elektrischen Bauelements durch den Alterungspuls verändert wird.

4. Verfahren nach Anspruch 1, wobei das elektrische Bauelement nach Anlegen des Alterungspulses im Betrieb nur noch geringfügig altert.

5. Verfahren nach Anspruch 1, wobei der Alterungspuls eine Pulshöhe von 500V bis 8000V aufweist.

6. Verfahren nach Anspruch 1, wobei der Alterungspuls eine Pulslänge von 10ns bis 1000ns aufweist.

7. Verfahren nach Anspruch 1, wobei der Alterungspuls eine Anstiegszeit von 0,1ns bis 10ns aufweist.

8. Verfahren nach einem der Ansprüche 1 bis 7, wobei der Alterungspuls auf einen Varistor angewandt wird.

9. Verfahren nach Anspruch 8, wobei der Varistor eine Varistorspannung aufweist, die durch den Alterungspuls stabilisiert wird.

10. Elektrisches Bauelement, das nach Anwendung eines Verfahrens nach einem der Ansprüche 1 bis 7 eine maximale ESD-Degradation einer elektrischen Kennlinie von 1% aufweist.

11. Elektrisches Bauelement nach Anspruch 10, wobei es sich um einen Varistor, ein PTC-Element oder ein NTC-Element handelt.

## Claims

1. Method for increasing the ESD pulse stability of an electrical component,
- wherein a pulse is generated by a pulse generator and a component provided is pre-pulsed with the pulse,
**characterized in that**
- the pulse is an ageing pulse having a pulse shape, wherein the pulse shape is chosen in such a way that the component is pre-aged and not damaged by means of the energy input of the ageing pulse,
- as a result of which the degradation of an electrical characteristic curve of the component by ESD pulses which occur during the operation of the electrical component is reduced.

2. Method according to Claim 1, wherein a linear or non-linear resistor is used as the electrical component.

3. Method according to Claim 1, wherein at least one electrical characteristic variable of the electrical component is altered by the ageing pulse.

4. Method according to Claim 1, wherein the electrical component ages only slightly during operation after the application of the ageing pulse.

5. Method according to Claim 1, wherein the ageing pulse has a pulse height of 500 V to 8000 V.

6. Method according to Claim 1, wherein the ageing pulse has a pulse length of 10 ns to 1000 ns.

7. Method according to Claim 1, wherein the ageing pulse has a rise time of 0.1 ns to 10 ns.

8. Method according to any of Claims 1 to 7, wherein the ageing pulse is applied to a varistor.

9. Method according to Claim 8, wherein the varistor has a varistor voltage that is stabilized by the ageing pulse.

10. Electrical component which has a maximum ESD degradation of an electrical characteristic curve of 1% after the application of a method according to any of Claims 1 to 7.

11. Electrical component according to Claim 10, wherein a varistor, a PTC element or a NTC element is involved.

## Revendications

1. Procédé pour augmenter la stabilité aux impulsions ESD d'un composant électrique,
- une impulsion étant générée par un générateur d'impulsions et un composant mis à disposition étant pré-exposé à l'impulsion,
**caractérisé en ce que**
- l'impulsion est une impulsion de vieillissement ayant une forme d'impulsion, la forme d'impulsion étant choisie de telle sorte que l'élément structural est vieilli prématurément par l'apport d'énergie de l'impulsion de vieillissement et n'est pas endommagé,
- la dégradation d'une courbe caractéristique électrique du composant par les impulsions ESD qui se produisent pendant le fonctionnement du composant électrique étant ainsi réduite.

2. Procédé selon la revendication 1, le composant électrique utilisé étant une résistance linéaire ou non linéaire.

3. Procédé selon la revendication 1, une grandeur caractéristique électrique du composant électrique étant modifiée par l'impulsion de vieillissement.

4. Procédé selon la revendication 1, le composant électrique ne vieillissant plus que légèrement en fonctionnement après l'application de l'impulsion de vieillissement.

5. Procédé selon la revendication 1, l'impulsion de vieillissement possédant une hauteur d'impulsion de 500 V à 8000 V.

6. Procédé selon la revendication 1, l'impulsion de vieillissement possédant une durée d'impulsion de 10 ns à 1000 ns.

7. Procédé selon la revendication 1, l'impulsion de vieillissement possédant un temps de montée de 0,1 ns à 10 ns.

8. Procédé selon l'une des revendications 1 à 7, l'impulsion de vieillissement étant appliquée sur une varistance.

9. Procédé selon la revendication 8, la varistance possédant une tension de varistance qui est stabilisée par l'impulsion de vieillissement.

10. Composant électrique qui, après l'utilisation d'un procédé selon l'une des revendications 1 à 7, présente une dégradation ESD maximale d'une courbe caractéristique électrique de 1 %.

11. Composant électrique selon la revendication 10, celui-ci étant une varistance, un élément à CTP ou un élément à CTN.
